# EUROPEAN PATENT SPECIFICATION

(11) **EP 3 723 464 B1**
(45) Date of publication and mention of the grant of the patent: **14.06.2023**
(21) Application number: 19168951.2
(22) Date of filing: 12.04.2019
(51) Int. Cl.: H05K 7/20, F28F 3/12, H01L 23/473

(54) **COLD PLATE FOR COOLING HIGH HEAT FLUX APPLICATIONS**
KÜHLPLATTE ZUR KÜHLUNG VON ANWENDUNGEN MIT HOHEM WÄRMEFLUSS
PLAQUE FROIDE POUR REFROIDIR LES APPLICATIONS À FLUX THERMIQUE ÉLEVÉ

(43) Date of publication of application: 14.10.2020
(73) Proprietor: ABB E-mobility B.V., 2629 JG Delft (NL)
(72) Inventor: BEL FDHILA, Rebei, 724 76 Västerås (SE)
(74) Representative: Kransell & Wennborg KB

(56) References cited:
- EP-A1- 3 136 434
- WO-A1-99/06782
- WO-A1-2020/060227
- US-A1- 2007 240 860

## Description

### TECHNICAL FIELD

The present disclosure relates to cold plates such as cold plates for cooling high heat flux elements.

### BACKGROUND

It is generally a challenge within several industrial applications to be able to cool objects that generate a large amount of heat. Such objects may for example typically be power electronic components, such as insulated gate bipolar transistor (IGBT) switches, or various types of processors.

For low heat flux generating objects, a heatsink using fins to increase the contact surface with the cold air may suffice. However, for objects generating larger heat fluxes, a cold plate with piped liquid flowing through it may be necessary.

JPH03278015 A discloses a cold plate for cooling a glass plate used for microscopes. The cold plate has two glass plates, between which a cooling passage is formed. The hard glass plates can have a thickness of 0.4 µm. There are also fluid distribution spacers arranged between the plates, which have a thickness of 0.5 µm.

EP 3 434 A1 discloses a thermal interface element comprising a thermal interface material and a circulating fluid. The thermal interface material comprises a first graphene sheet, a second graphene sheet, and an array of carbon nanotubes. The array of carbon nanotubes is arranged between the first graphene sheet and the second graphene sheet, such that the carbon nanotubes of the array are in thermal contact with the first graphene sheet and the second graphene sheet. The circulating fluid is in fluid communication with the array of carbon nanotubes.

US 2007/240860 A1 discloses a support structure for a compact planar cooling device. The cooling device includes a planar casing, a wick layer, and the support structure. The support structure includes a flat plate with a portion cut out to form an opening and a spacer on the flat plate. The spacer is made by bending or folding the cut-out portion of the plate. The spacer enhances coolant circulation inside the cooling device by pushing the wick layer against the inner surface of the casing and maintaining a set distance between the support structure and the casing to allow unimpeded coolant movement. The support structure is meant to be a simple alternative for pillars with a wick layer around them.

WO 99/06782 A1 discloses an apparatus that includes a plate which is configured to carry an electronic component and which has a thermally-conductive porous medium disposed therein. The porous medium is sized to receive a fluid. When an electronic component is disposed on the plate and a fluid passes through the thermally-conductive porous medium, at least a portion of the fluid boils and heat is removed from the electronic component by conduction and phase change effects.

WO2020060227 A1 discloses a heat dissipation device in the form of a heat pipe or vapor chamber, with a wick and hollow or porous fillers.

### SUMMARY

A general object of the present disclosure is to provide a cold plate which solves or at least mitigates the problems of the prior art.

There is hence provided a cold plate comprising: a base structure, a cooling layer, and at least one porous or hollow spacer provided between the base structure and the cooling layer, whereby a cooling channel structure is formed between the base structure and the cooling layer.

By means of the at least one porous or hollow spacer, the surface of the cooling layer which is in contact with the cooling fluid is increased because cooling fluid flowing inside the porous or hollow spacer will also have contact with the cooling layer. The cooling hence becomes more efficient. Additionally, the porous or hollow structure reduces the pressure drop in the cold plate compared to a solid spacer. Furthermore, the porous or hollow spacer(s) act as local mixers, which makes the fluid temperature more uniform throughout the cold plate.

The cooling layer is in use arranged in contact, e.g. in direct contact, with a heat source such as a power electronics component or a processor.

According to one embodiment the cooling layer has a thickness equal to or less than 10 micrometres.

According to one embodiment the cooling layer has a thickness equal to or less than 1 micrometres.

According to one embodiment the cooling layer has a thickness equal to or less than 0.1 micrometre.

According to one embodiment the cooling layer has a thickness equal to or less than 10 nanometres, such as equal to or less than 1 nanometre.

Due to the thinness of the cooling layer, the cooling fluid will flow very close to the heat source. The cooling layer essentially functions as a skin due to its thinness. Due to the thinness of the cooling layer, the cooling layer may beneficially be made of a non-metallic material. In the design of the cold plate, the thermal conductivity of the cooling layer is not a limiting factor for efficient cooling.

The at least one porous or hollow spacer comprises a plurality of orifices, or through-openings, which form the porous or hollow structure of the at least one porous or hollow spacer.

According to one embodiment cooling channels formed between the at least one porous or hollow spacer, the base structure and the cooling layer, and orifices formed in the at least one porous or hollow spacer occupy at least 80%, such as at least 85% or 90%, of the space between the base structure and the cooling layer. The larger the volume occupied by the cooling channels and the orifices of the at least one porous or hollow spacer, the more efficient is the cooling.

According to one embodiment the at least one porous or hollow spacer is a structured porous or hollow media.

According to one embodiment the structured porous or hollow media is a triply periodic minimal surface, TPMS, structure.

According to one embodiment the cooling layer is made of a non-metallic material. The cooling layer could alternatively be made of metal, such as copper, aluminium or steel.

According to one embodiment the cooling layer is composed of graphene. The cooling layer may hence for example consist of graphene. The cooling layer may for example consist of a monolayer of graphene such as a monolayer graphene sheet.

The cooling layer may according to one example be made of a dielectric material, such as a polymeric material or a ceramic. The cold plate may according to one example be made of a dielectric material. Hence, the porous or hollow spacers, the base structure and the cooling layer may be made of a dielectric material.

The cold plate may comprise a thermally conductive material layer provided on the cooling layer. The thermally conductive material layer may be deformable and/or elastic. The thermally conductive material layer may for example consist of a monolayer of thermally conductive material such as a monolayer of graphene. The cooling layer may have an external cooling surface, and the thermally conductive material layer may be provided on the external cooling surface. The mechanical contact between the cooling layer and the heat source may thereby be improved.

The cooling layer may according to one example be composed of a polymeric material such as a thermoplastic, e.g. polyethylene or polypropylene.

According to one embodiment the cold plate is a power electronics cold plate. The cold plate is hence according to this example designed for cooling a power electronics component.

According to one embodiment the at least one porous or hollow spacer is integral with at least one of the base structure and the cooling layer.

According to one embodiment the at least one porous or hollow spacer is porous or hollow along its entire extension between the base structure and the cooling layer.

One embodiment comprises a plurality of porous or hollow spacers provided between the base structure and the cooling layer. A plurality of cooling channels may thereby be formed between the base structure, the cooling layer and the plurality of porous or hollow spacers.

The plurality of cooling channels may for example be branched with a structure reminiscent of a biological system such as blood vessels.

The cross-sectional area of at least some of the cooling channels may be different. The cross-sectional area of at least some of the cooling channels may vary in the main cooling fluid flow direction of the cooling fluid inside the cold plate.

According to one example, in some regions of the cold plate the cooling channels may be more densely arranged than in other regions of the cold plate.

All the porous or hollow spacers may according to one example have the same structure. According to one example, at least one of the porous or hollow spacers may have a different structure than the other porous or hollow spacers.

The porous or hollow spacer(s) may be of the same material as the cooling layer or the porous or hollow spacer(s) may be made of a different material than the cooling layer. For example, the one or more porous or hollow spacers may be made of the same material as the base structure.

The cooling channels may be provided in great proximity to each other. The porous or hollow spacers may hence have very small dimensions or thickness in the direction in which they define separation between adjacent cooling channels. This dimension or thickness, which separates two adjacent cooling channels, may for example be equal to or less than to µm, such as equal to or less than 1 µm, such as equal to or less than 0.1 µm, such as equal to or less than 10 nanometres.

According to one embodiment the at least one porous or hollow spacer is a single porous or hollow spacer which occupies the entire space between the base structure and the cooling layer, wherein the cooling channel structure is formed by orifices in the porous or hollow spacer.

The cold plate may for example be manufactured by means of additive manufacturing, such as 3-d printing.

The cooling channels may according to one example be partly or fully filled with a foam. Heat transfer may thereby be improved.

According to one example, the cold plate comprises a second cooling layer, and at least one additional porous or hollow spacer arranged between the base structure and the second cooling layer. The cold plate may in this case have two cooling layers with the base structure sandwiched in between the two cooling layers. Cooling from two opposing sides of the cold plate may thereby be provided. The second cooling layer may have the same properties as any examples of the cooling layer disclosed herein. The at least one additional porous or hollow spacer may have the same properties as any examples of the porous or hollow structure disclosed herein.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

Examples of the inventive concept will now be described, by way of example, with reference to the accompanying drawings, in which:
Fig. 1a shows a sectional side view of an example of a cold plate;
Fig. 1b shows a sectional side view of the cold plate in Fig. 1a from a direction perpendicular to the direction in Fig. 1a; and
Fig. 2 schematically shows a top view of an example of a cold plate, with the cooling layer removed.

### DETAILED DESCRIPTION

The inventive concept will now be described more fully hereinafter with reference to the accompanying drawings, in which certain embodiments of the inventive concept are shown. This invention may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

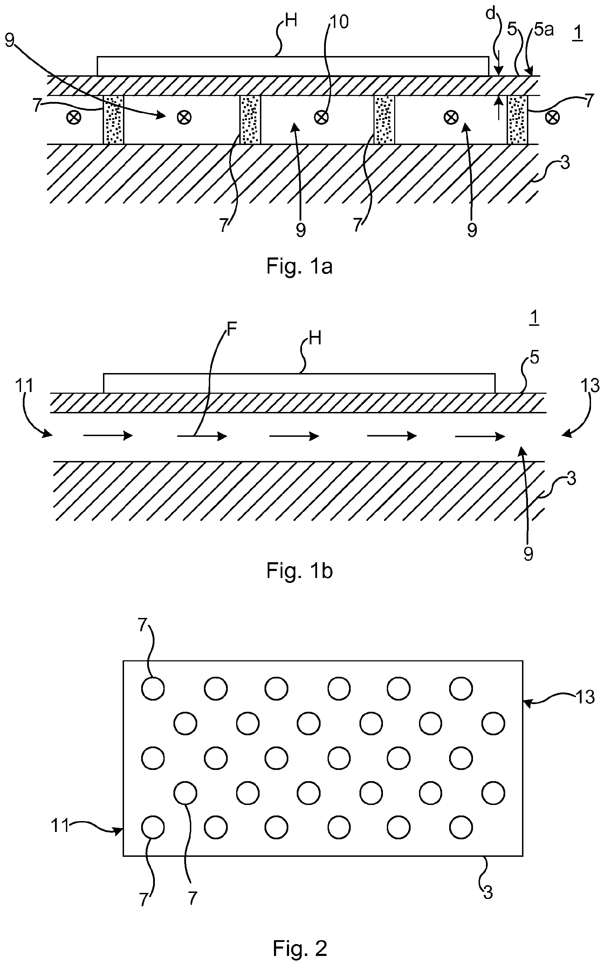

Fig. 1 schematically depicts a sectional side view of an example of a cold plate 1, in the art sometimes also referred to as a cooling plate. The exemplified cold plate 1 is designed and configured to cool a high heat flux heat source such as an electronic heat source e.g. a power electronics component or other electronics component such as a processor, for example a microprocessor.

The cold plate 1 comprises a base structure or substrate 3, a cooling layer 5, and a plurality of porous or hollow spacers 7.

The porous or hollow spacers 7 are arranged between the base structure 3 and the cooling layer 5. The porous or hollow spacers 7 space apart the base structure 3 and the cooling layer 5. The porous or hollow spacers 7 are provided with a plurality of orifices which define the porous or hollow structure of the porous or hollow spacers 7. Each porous or hollow spacer 7 is configured to enable cooling fluid to flow through its orifices. The orifices may be distributed along the entire length of the porous or hollow spacers 7 as they extend between the base structure 3 and the cooling layer 5. The porous or hollow spacers 7 may be provided with a plurality of orifices in a region where the porous or hollow spacers 7 transition to the cooling layer 5. Cooling fluid is thereby able to flow through the porous or hollow spacers 7 near the cooling layer 5. The surface area where the cooling fluid directly or essentially directly cools or contacts the cooling layer 5 is thereby increased.

A cooling channel structure is formed by a plurality of cooling channels 9 defined or delimited by the inner surface of the base structure 3, the inner surface of the cooling layer 5 and the external surfaces of the porous or hollow spacers 7, and by the orifices of the porous or hollow spacers 7.

The cooling layer 5 defines an external cooling surface 5a. The cooling surface 5a may for example be flat or planar, or it may have a shape/structure adapted to the shape of a heat source which the cooling surface 5a is to cool. Fig. 1a depicts a heat source H which is arranged on the cooling surface 5a, to be cooled by the cold plate 1, in particular via the cooling layer 5.

Each or at least some of the cooling channels 9 may according to one variation have a fixed cross-sectional area along its/their length as they extend between the base structure 3 and the cooling layer 5. As an alternative, some or all of the cooling channels 9 may have a varying cross-sectional area along their length. There are also examples where the cooling channels are open with respect to each other, with the spacers being arranged in a column-like configuration instead of separating walls, as in the example shown in Fig. 2. According to one example, in some regions of the cold plate 1, the cooling channels 9 may be more densely arranged than in other regions. Hereto, there may be more cooling channels 9 in some regions than in others.

Some or all of the porous or hollow spacers 7 may according to one example be structured porous or hollow media, such as TPMS structures. According to one example of the cold plate, the cold plate may comprise only a single porous or hollow spacer, which may occupy the entire space between the base structure and the cooling layer. In this case, the orifices form the cooling channels. The porous or hollow structure may in this case for example be a TPMS structure.

The cooling layer 5 has a thickness d. The thickness d may for example be equal to or less than 10 micrometres, such as equal to or less than 1 micrometres, such as equal to or less than 0.1 micrometres, such as equal to or less than 10 nanometres, such as equal to or less than 1 nanometre. The cooling layer 5 may be composed of a non-metallic material, such as graphene, e.g. carbon nanotubes, other nanotube types, or a polymer such as a thermoplastic. Alternatively, the cooling layer 5 may be composed of a metal material, for example aluminium, copper, or steel. In case the cooling layer 5 is very thin, the porous or hollow spacers 7 may be distributed such that they provide adequate support for the cooling layer 5 to be able to support the heat source.

The cold plate 1, or at least part of the cold plate 1 may be manufactured using additive manufacturing. For example, the base structure 3, the one or more porous or hollow spacers 7, and the cooling layer 5 may all be made using additive manufacturing. Alternatively, at least one of the porous or hollow spacer(s) 7 and the cooling layer 5 may be made using additive manufacturing.

In the example shown in Fig. 1a, the circles with crosses 10 indicate a fluid flow in a direction into the figure. According to the example, the general flow direction is the same in all the cooling channels 9. The cooling fluid may typically be a liquid, such as water, but could alternatively be a gas or a gas-liquid mixture.

Fig. 1b shows the cold plate 1 from a direction perpendicular to that shown in Fig. 1a. The cold plate 1 has a cooling fluid inlet 11 and a cooling fluid outlet 13. The cooling channels 9 are connected to the cooling fluid inlet 11 and to the cooling fluid outlet 13. The arrows F show a cooling fluid which flows in a cooling channel 9 from the cooling fluid inlet 11 to the cooling fluid outlet 13.

Fig. 2 shows a top view of an example of a cold plate 1 in which the cooling layer 5 has been removed to expose an example configuration of the porous or hollow spacers 7 schematically. The porous or hollow spacers 7 are arranged as columns extending between the base structure 3 and the cooling layer 5. The porous or hollow spacers 7 are arranged in rows between the cooling fluid inlet 11 and the cooling fluid outlet 13. Adjacent rows are arranged offset from each other. For example, the rows may mutually be offset corresponding to half the distance between two adjacent porous or hollow spacers 7 arranged in the same row.

According to at least some examples disclosed herein, the one or more porous or hollow spacers 7 are integral with at least one of the base structure 3 and the cooling layer 5. The one or more porous or hollow spacers 7 may hence form a monolithic structure with the base structure 3 and/or the cooling layer 5. For example, the one or more porous or hollow spacers 7 may be integral with only the base structure 3 or only with the cooling layer 5. This may for example be achieved by means of additive manufacturing such as 3-d printing.

The invention has mainly been described above with reference to a few embodiments. However, as is readily appreciated by a person skilled in the art, other embodiments than the ones disclosed above are equally possible within the scope of the invention, as defined by the appended patent claims.

## Claims

1. A cold plate (1) comprising:
a base structure (3),
a cooling layer (5), a cooling fluid inlet (11), a cooling fluid outlet (13) and
at least one porous or hollow spacer (7), each porous or hollow spacer (7) being configured to enable cooling fluid to flow through its orifices, the at least one porous or hollow spacer being provided between the base structure (3) and the cooling layer (5), whereby a cooling channel structure is formed by a plurality of cooling channels (9) defined or delimited by the inner surface of the base structure (3), the inner surface of the cooling layer (5) and the external surfaces of the porous or hollow spacers (7), and by the orifices of the porous or hollow spacers (7), wherein the cooling channels (9) are connected to the cooling fluid inlet (11) and the cooling fluid outlet (13).

2. The cold plate (1) as claimed in claim 1, wherein the cooling layer (5) has a thickness, d, equal to or less than 10 micrometres.

3. The cold plate (1) as claimed in claim 1 or 2, wherein the cooling layer (5) has a thickness, d, equal to or less than 1 micrometres.

4. The cold plate (1) as claimed in any of the preceding claims, wherein the cooling layer (5) has a thickness, d, equal to or less than 0.1 micrometre.

5. The cold plate (1) as claimed in any of the preceding claims, wherein the cooling layer (5) has a thickness, d, equal to or less than 10 nanometres.

6. The cold plate (1) as claimed in any of the preceding claims, wherein cooling channels (9) formed between the at least one porous or hollow spacer (7), the base structure (3) and the cooling layer (5), and orifices formed in the at least one porous or hollow spacer occupy at least 80% of the space between the base structure (3) and the cooling layer (5).

7. The cold plate (1) as claimed in any of the preceding claims, wherein the at least one porous or hollow spacer (7) is a structured porous or hollow media.

8. The cold plate (1) as claimed in claim 7, wherein the structured porous or hollow media is a triply periodic minimal surface, TPMS, structure.

9. The cold plate (1) as claimed in any of the preceding claims, wherein the cooling layer (5) is made of a non-metallic material.

10. The cold plate (1) as claimed in any of the preceding claims, wherein the cooling layer (5) is composed of graphene.

11. The cold plate (1) as claimed in any of the preceding claims, wherein the cold plate (1) is a power electronics cold plate.

12. The cold plate (1) as claimed in any of the preceding claims, wherein the at least one porous or hollow spacer (7) is integral with at least one of the base structure (3) and the cooling layer (5).

13. The cold plate (1) as claimed in any of the preceding claims, wherein the at least one porous or hollow spacer (7) is porous or hollow along its entire extension between the base structure (3) and the cooling layer (5).

14. The cold plate (1) as claimed in any of the preceding claims, comprising a plurality of porous or hollow spacers (7) provided between the base structure (3) and the cooling layer (5).

## Patentansprüche

1. Kühlplatte (1), umfassend:
eine Basisstruktur (3),
eine Kühlschicht (5), einen Kühlfluideinlass (11), einen Kühlfluidauslass (13) und wenigstens einen porösen oder hohlen Abstandshalter (7), wobei jeder poröse oder hohle Abstandshalter (7) dafür gestaltet ist, Durchtreten von Kühlfluid durch seine Öffnungen zu erlauben, wobei der wenigstens eine poröse oder hohle Abstandshalter zwischen der Basisstruktur (3) und der Kühlschicht (5) angeordnet ist, wobei eine Vielzahl von Kühlkanälen (9), die von der Innenoberfläche der Basisstruktur (3), der Innenoberfläche der Kühlschicht (5) und den Außenoberflächen des porösen oder hohlen Abstandshalters (7) und von den Öffnungen des porösen oder hohlen Abstandshalters (7) definiert oder begrenzt werden, eine Kühlkanalstruktur bilden, wobei die Kühlkanäle (9) mit dem Kühlfluideinlass (11) und dem Kühlfluidauslass (13) verbunden sind.

2. Kühlplatte (1) gemäß Anspruch 1, wobei die Kühlschicht (5) eine Dicke d von gleich oder kleiner als 10 Mikrometer aufweist.

3. Kühlplatte (1) gemäß Anspruch 1 oder 2, wobei die Kühlschicht (5) eine Dicke d von gleich oder kleiner als 1 Mikrometer aufweist.

4. Kühlplatte (1) gemäß einem der vorstehenden Ansprüche, wobei die Kühlschicht (5) eine Dicke d von gleich oder kleiner als 0,1 Mikrometer aufweist.

5. Kühlplatte (1) gemäß einem der vorstehenden Ansprüche, wobei die Kühlschicht (5) eine Dicke d von gleich oder kleiner als 10 Nanometer aufweist.

6. Kühlplatte (1) gemäß einem der vorstehenden Ansprüche, wobei Kühlkanäle (9) zwischen dem wenigstens einen porösen oder hohlen Abstandshalter (7), der Basisstruktur (3) und der Kühlschicht (5) gebildet werden und in dem wenigstens einen porösen oder hohlen Abstandshalter gebildete Öffnungen wenigstens 80 % des Raums zwischen der Basisstruktur (3) und der Kühlschicht (5) einnehmen.

7. Kühlplatte (1) gemäß einem der vorstehenden Ansprüche, wobei der wenigstens eine poröse oder hohle Abstandshalter ein strukturiertes poröses oder hohles Medium ist.

8. Kühlplatte (1) gemäß Anspruch 7, wobei das strukturierte poröse oder hohle Medium eine Struktur mit dreifach periodischer Minimaloberfläche, TPMS, ist.

9. Kühlplatte (1) gemäß einem der vorstehenden Ansprüche, wobei die Kühlschicht (5) aus einem nichtmetallischen Material besteht.

10. Kühlplatte (1) gemäß einem der vorstehenden Ansprüche, wobei die Kühlschicht (5) aus Graphen besteht.

11. Kühlplatte (1) gemäß einem der vorstehenden Ansprüche, wobei die Kühlplatte (1) eine Leistungselektronik-Kühlplatte ist.

12. Kühlplatte (1) gemäß einem der vorstehenden Ansprüche, wobei der wenigstens eine poröse oder hohle Abstandshalter (7) mit wenigstens einem von der Basisstruktur (3) und der Kühlschicht (5) integral ist.

13. Kühlplatte (1) gemäß einem der vorstehenden Ansprüche, wobei der wenigstens eine poröse oder hohle Abstandshalter (7) entlang seiner gesamten Ausdehnung zwischen der Basisstruktur (3) und der Kühlschicht (5) porös oder hohl ist.

14. Kühlplatte (1) gemäß einem der vorstehenden Ansprüche, umfassend eine Vielzahl von porösen oder hohlen Abstandshaltern (7), die zwischen der Basisstruktur (3) und der Kühlschicht (5) bereitgestellt sind.

## Revendications

1. Plaque froide (1) comprenant :
une structure de base (3),
une couche de refroidissement (5), une entrée de fluide de refroidissement (11), une sortie de fluide de refroidissement (13) et
au moins une entretoise poreuse ou creuse (7), chaque entretoise poreuse ou creuse (7) étant configurée pour permettre à un fluide de refroidissement de s'écouler à travers ses orifices, l'au moins une entretoise poreuse ou creuse étant disposée entre la structure de base (3) et la couche de refroidissement (5), moyennant qui une structure de canaux de refroidissement est formée par une pluralité de canaux de refroidissement (9) définis ou délimités par la surface interne de la structure de base (3), la surface interne de la couche de refroidissement (5) et les surfaces externes des entretoises poreuses ou creuses (7), et par les orifices des entretoises poreuses ou creuses (7), dans laquelle les canaux de refroidissement (9) sont reliés à l'entrée de fluide de refroidissement (11) et la sortie de fluide de refroidissement (13).

2. Plaque froide (1) selon la revendication 1, dans laquelle la couche de refroidissement (5) a une épaisseur, d, égale ou inférieure à 10 micromètres.

3. Plaque froide (1) selon la revendication 1 ou 2, dans laquelle la couche de refroidissement (5) a une épaisseur, d, égale ou inférieure à 1 micromètre.

4. Plaque froide (1) selon l'une quelconque des revendications précédentes, dans laquelle la couche de refroidissement (5) a une épaisseur, d, égale ou inférieure à 0,1 micromètre.

5. Plaque froide (1) selon l'une quelconque des revendications précédentes, dans laquelle la couche de refroidissement (5) a une épaisseur, d, égale ou inférieure à 10 nanomètres.

6. Plaque froide (1) selon l'une quelconque des revendications précédentes, dans laquelle des canaux de refroidissement (9) formés entre l'au moins une entretoise poreuse ou creuse (7), la structure de base (3) et la couche de refroidissement (5), et des orifices formés dans l'au moins une entretoise poreuse ou creuse occupent au moins 80 % de l'espace entre la structure de base (3) et la couche de refroidissement (5) .

7. Plaque froide (1) selon l'une quelconque des revendications précédentes, dans laquelle l'au moins une entretoise poreuse ou creuse (7) est un milieu poreux ou creux structuré.

8. Plaque froide (1) selon la revendication 7, dans laquelle le milieu poreux ou creux structuré est une structure de surface minimale triplement périodique, TPMS.

9. Plaque froide (1) selon l'une quelconque des revendications précédentes, dans laquelle la couche de refroidissement (5) est constituée d'un matériau non métallique.

10. Plaque froide (1) selon l'une quelconque des revendications précédentes, dans laquelle la couche de refroidissement (5) est composée de graphène.

11. Plaque froide (1) selon l'une quelconque des revendications précédentes, la plaque froide (1) étant une plaque froide d'électronique de puissance.

12. Plaque froide (1) selon l'une quelconque des revendications précédentes, dans laquelle l'au moins une entretoise poreuse ou creuse (7) fait partie intégrante de la structure de base (3) et/ou de la couche de refroidissement (5).

13. Plaque froide (1) selon l'une quelconque des revendications précédentes, dans laquelle l'au moins une entretoise poreuse ou creuse (7) est poreuse ou creuse sur son étendue entière entre la structure de base (3) et la couche de refroidissement (5).

14. Plaque froide (1) selon l'une quelconque des revendications précédentes, comprenant une pluralité d'entretoises poreuses ou creuses (7) disposées entre la structure de base (3) et la couche de refroidissement (5) .
